(19) Europäisches Patentamt
European Patent Office
Office européen des brevets

(11) **EP 2 909 725 B1**

(12) **FASCICULE DE BREVET EUROPEEN**

(45) Date de publication et mention de la délivrance du brevet:
**16.06.2021 Bulletin 2021/24**

(21) Numéro de dépôt: **13786693.5**

(22) Date de dépôt: **10.10.2013**

(51) Int Cl.:
***G06F 11/10*** *(2006.01)*

(86) Numéro de dépôt international:
**PCT/FR2013/052417**

(87) Numéro de publication internationale:
**WO 2014/060683 (24.04.2014 Gazette 2014/17)**

(54) **PROCÉDÉ ET DISPOSITIF POUR AMÉLIORER LA FIABILITÉ DE MÉMORISATION DE DONNÉES DANS UN DISQUE DUR COMPRENANT PLUSIEURS PLATEAUX**

VERFAHREN UND VORRICHTUNG ZUR VERBESSERUNG DER ZUVERLÄSSIGKEIT DER DATENSPEICHERUNG IN EINER FESTPLATTE MIT MEHREREN SCHEIBEN

METHOD AND DEVICE FOR IMPROVING THE RELIABILITY OF STORING DATA IN A HARD DISK WITH MULTIPLE PLATES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2012 FR 1259858**

(43) Date de publication de la demande:
**26.08.2015 Bulletin 2015/35**

(73) Titulaire: **Bull SAS**
**78340 Les Clayes-sous-Bois (FR)**

(72) Inventeurs:
• **MARTINEZ, Patrice**
  **F-38100 Grenoble (FR)**
• **CRISAN, Cornel**
  **F-38700 La Tronche (FR)**

(74) Mandataire: **Argyma**
  **14 Boulevard de Strasbourg**
  **31000 Toulouse (FR)**

(56) Documents cités:
**US-A1- 2006 107 131     US-B1- 6 546 499**

EP 2 909 725 B1

**Description**

La présente invention concerne la mémorisation de données dans des mémoires de masse et plus particulièrement un procédé et un dispositif pour améliorer la fiabilité de mémorisation de données dans un disque dur comprenant plusieurs plateaux.

Le traitement d'informations dans des systèmes informatiques nécessite la mémorisation d'un volume de données potentiellement important. A ces fins, il existe différents types de supports de stockage de données ayant chacun des caractéristiques particulières, pouvant être accédés en lecture et/ou en écriture.

Ainsi, par exemple, il existe des mémoires dites vives dont l'accès est très rapide. Cependant, le prix de ces mémoires est généralement assez élevé et elles sont souvent volatiles, c'est-à-dire que les données sont perdues lorsque la mémoire n'est plus alimentée électriquement.

Alternativement, il existe des mémoires pour le stockage de masse telle que des disques durs. De tels moyens de stockage permettent de mémoriser un très grand nombre de données de façon non volatile. Cependant, l'accès aux données mémorisées dans de tels moyens de stockage est relativement lent du fait, notamment, des éléments mécaniques mis en œuvre.

Par conséquent, les systèmes informatiques utilisent généralement plusieurs types de supports de stockage de façon concomitante.

Par ailleurs, pour tenir compte d'éventuelles erreurs de lecture ou d'écriture dans ces mémoires, il existe des mécanismes de contrôle pour détecter des erreurs ainsi que des mécanismes de correction d'erreurs. A titre d'illustration, de tels mécanismes peuvent utiliser des calculs de parité, de quorum ou des codes correcteurs d'erreurs. Ces différentes techniques peuvent également être combinées.

Un calcul de parité a pour objet de calculer une somme de contrôle (appelée *ckecksum* en terminologie anglo-saxonne), ou empreinte. Le résultat est transmis avec les données à transmettre et permet au récepteur de vérifier que les données reçues sont bien les données transmises. Il permet également, dans certains cas, de retrouver un élément manquant d'une donnée. Une somme de contrôle est une donnée redondante.

Une somme de contrôle peut, par exemple, être obtenue à l'aide de la fonction logique XOR.

A titre d'illustration, si une donnée à transmettre est codée de la façon suivante, 011010110111, la somme de contrôle est égale à 0 (résultat de la fonction XOR appliquée à l'ensemble des éléments de la donnée transmise). Si la donnée reçue, correspondant à la donnée transmise 011010110111, est 011000110111, le récepteur détecte une erreur de transmission car la somme de contrôle de la donnée reçue est égale à 1 (résultat de la fonction XOR appliquée à l'ensemble des éléments de la donnée reçue). De même, si la donnée reçue, correspondant à la donnée transmise 011010110111, est 0110x0110111, où x représente un élément non reçu, cet élément peut être retrouvé pour que la somme de contrôle des éléments de la donnée reçue soit égale à la somme de contrôle des éléments de la donnée transmise.

Il existe, en particulier, un type de code correcteur d'erreurs, connu sous le nom de code cyclique (ou CRC pour *Cyclic Redundancy Check* en terminologie anglo-saxonne), qui est couramment utilisé en informatique. Il repose sur l'utilisation des propriétés de polynômes et consiste à considérer un bloc de donnée comme la représentation des coefficients d'un polynôme que l'on divise ensuite par un polynôme fixe et prédéterminé. Les coefficients issus de cette division constituent le CRC et servent de code correcteur.

Ainsi, par exemple, pour coder un mot de $m$ bits, $n$ bits sont utilisés, avec $n > m$, où la différence entre les valeurs $n$ et $m$ représente la redondance et détermine, selon l'algorithme utilisé, le nombre de bits pouvant être corrigés.

A titre d'illustration, le code correcteur de blocs de 8 bits, connu sous le nom de BEC (acronyme de *Block Error Code* en terminologie anglo-saxonne), dérivant de la théorie de Bose-Chaudhuri-Hocquenghem, permet de corriger des erreurs multiples distribuées de façon aléatoire. En utilisant deux octets supplémentaires par mots de 64 bits, mémorisés par blocs de 8 bits, il est possible de corriger jusqu'à 8 bits dans un bloc.

Le document US 2006/0107131 décrit par exemple un disque dur comportant une pluralité de plateaux et un procédé pour améliorer la fiabilité d'un disque dur.

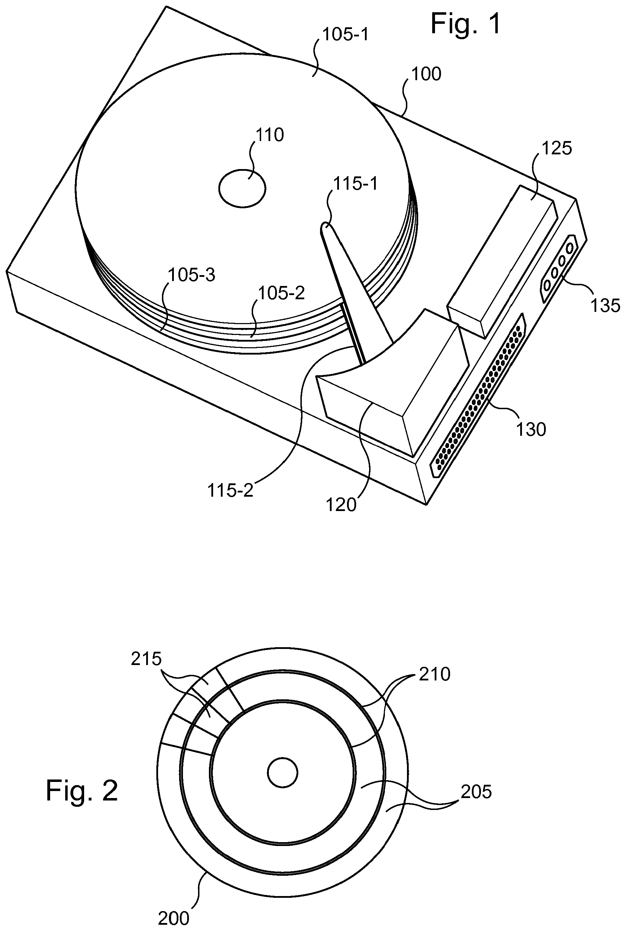

La figure 1 illustre schématiquement la structure d'un disque dur. Comme représenté, il comprend un boîtier 100 dans lequel est généralement agencée une pluralité de plateaux référencés ici 105-1 à 105-3. Ces derniers sont montés sur un même axe 110 et sont entraînés par un moteur (non représenté). Typiquement, chaque plateau comprend une face supérieure et une face inférieure sur chacune desquelles des données peuvent être écrites ou lues selon un principe de polarisation magnétique.

La lecture et l'écriture de données sur la surface d'un plateau sont réalisées à l'aide de têtes de lecture et d'écriture disposées à l'extrémité d'un bras mobile permettant de déplacer les têtes selon un axe radial du plateau. Chacune ces têtes évolue, en général, à quelques nanomètres de la surface des plateaux.

De façon standard, un disque dur comprend un nombre de bras égal au nombre de plateaux plus un de telle sorte qu'un bras soit disposé au-dessus de la face supérieure du plateau supérieur (ici le bras référencé 115-1), qu'un bras soit disposé au-dessous de la face inférieure du plateau inférieur (bras non visible ici) et qu'un bras soit disposé entre chaque paire de plateaux adjacents comme le bras 115-2 disposé entre la face inférieure du plateau 105-1 et la face supérieure du plateau 105-2.

Les bras sont généralement montés sur un même axe (non représenté) et solidaires les uns des autres. Leur mouvement est contrôlé par un servocommande 120.

Par ailleurs, un disque dur comprend un ensemble de circuits électroniques 125, appelé contrôleur de disque, pour l'asservissement des moteurs, c'est-à-dire le contrôle de la rotation des plateaux (génériquement référencés 105) et du mouvement des bras (génériquement référencés 115) et la lecture et l'écriture de données. Les circuits électroniques 125 comprennent souvent une mémoire tampon où sont stockées des données à écrire et/ou des données lues à transmettre à un dispositif distant.

Le disque dur comprend également une interface 130 pour le connecter à un périphérique distant, par exemple une interface conforme au standard IDE (sigle d'*Integrated Drive Electronics* en terminologie anglosaxonne), SCSI (sigle de *Small Computer System Interface* en terminologie anglo-saxonne), SATA (sigle de *Serial Advanced Technology Attachment* en terminologie anglo-saxonne) ou SAS (sigle de *Serial Attached SCSI* en terminologie anglo-saxonne), ainsi qu'une connexion 135 pour son alimentation électrique.

La figure 2 représente schématiquement la façon dont sont stockées des données sur une surface d'un plateau. Comme illustré, une surface d'un plateau 200 comprend un ensemble de pistes concentriques, génériquement référencées 205, séparées par des interpistes génériquement référencées 210. Les pistes sont divisées en secteurs 215 où peuvent être mémorisées des données.

Les données sont typiquement codées de façon continue au sein de chaque secteur mais les secteurs utilisés pour coder un ensemble de données ne sont que rarement contigus. Une adresse de donnée est, au sein d'un disque dur, typiquement définie par une référence de cylindre (représentant une piste), une référence de tête (étant observé que bien qu'un plateau soit généralement associé à une tête, plusieurs têtes peuvent être utilisées pour lire et/ou écrire des données sur une surface d'un plateau) et une référence de secteur.

Lorsqu'un disque dur connaît une défaillance, par exemple lorsqu'une tête de lecture heurte la surface d'un plateau, des données peuvent être définitivement perdues. Pour éviter de telles situations, les constructeurs de disques durs recommandent la mise en place d'un système de sauvegarde consistant à recopier l'intégralité des données sur un ou plusieurs autres disques durs ou à répartir des données sur plusieurs disques durs. Cette dernière solution, connue sous le nom d'architecture RAID (sigle de *Redundant Array of Independent/Inexpensive Disks* en terminologie anglo-saxonne), consiste à mémoriser une donnée dans plusieurs dispositifs distincts, avec une redondance, de telle sorte que si un des dispositifs est défaillant, les parties des données mémorisées dans les autres dispositifs permettent de les reconstituer.

Cependant, s'il existe des solutions pour permettre de reconstituer des données mémorisées dans un système ayant une architecture répartie, il n'existe pas de solution pour améliorer la fiabilité d'un système de stockage autonome.

L'invention permet de résoudre au moins un des problèmes exposés précédemment.

L'invention a ainsi pour objet un procédé pour contrôleur de disque dur comprenant une pluralité de plateaux, pour améliorer la fiabilité du disque dur, chaque plateau comprenant au moins une surface de stockage de données, le procédé comprenant les étapes suivantes :

- obtention d'une pluralité de blocs de donnée, chaque bloc de ladite pluralité de blocs de donnée devant être ou étant mémorisé dans le disque dur, le nombre de blocs de ladite pluralité de blocs de donnée étant inférieur au nombre de surfaces de plateaux du disque dur pouvant stocker des données ;

- calcul d'au moins un bloc de donnée de redondance en fonction de chaque bloc de ladite pluralité de blocs de donnée, le nombre de bloc de donnée de redondance ajouté au nombre de blocs de ladite pluralité de blocs de donnée étant inférieur ou égal au nombre de surfaces de plateaux du disque dur pouvant stocker des données ; et

- écriture dudit au moins un bloc de donnée de redondance sur une surface de plateau du disque dur, distincte des surfaces utilisées pour mémoriser chaque bloc de ladite pluralité de blocs de donnée.

Le procédé selon l'invention permet ainsi d'améliorer la fiabilité de stockage de données dans un disque dur en mémorisant les données et des données redondantes sur des plateaux distincts de telle sorte que si un plateau connaît des problèmes de lecture, les données puissent néanmoins être recouvrées.

Selon un mode de réalisation particulier, ladite étape d'obtention d'une pluralité de blocs de donnée comprend une étape de lecture, sur une surface de plateau du disque dur, d'au moins un bloc de ladite pluralité de blocs de donnée. Le procédé selon l'invention permet ainsi d'améliorer la fiabilité de stockage de données au moins partiellement mémorisées.

Toujours selon un mode de réalisation particulier, au moins un bloc de ladite pluralité de blocs de donnée est obtenu via une interface de communication.

Toujours selon un mode de réalisation particulier, le procédé comprend en outre une étape de décomposition d'une donnée reçue à mémoriser dans le disque dur en ladite pluralité de blocs de donnée.

Le procédé selon l'invention permet ainsi d'améliorer la fiabilité de stockage de données à mémoriser.

De façon avantageuse, le procédé comprend en outre une étape d'écriture d'au moins un bloc de ladite pluralité de blocs de donnée sur une surface de plateau du disque dur.

Selon l'invention, le procédé comprend en outre les étapes suivantes :

- accès à une pluralité de blocs de donnée correspondant à une donnée à lire dans le disque dur et accès à au moins un bloc de donnée de redondance correspondant à ladite donnée à lire, chaque bloc de ladite pluralité de blocs de donnée accédés et chaque bloc dudit au moins un bloc de donnée de redondance associé à ladite donnée à lire étant accédé sur une surface distincte de plateau du disque dur ; et
- vérification de l'intégrité de la donnée correspondant à ladite pluralité de blocs de donnée accédés selon ledit au moins un bloc de donnée de redondance correspondant à ladite donnée à lire pour détecter une éventuelle erreur de lecture.

Le procédé selon l'invention permet ainsi de vérifier que des données accédées dans un disque dur sont valides.

Selon un mode de réalisation particulier, ladite étape de vérification comprend une étape de calcul d'au moins un bloc de donnée de redondance.

Toujours selon un mode de réalisation particulier, le procédé comprend en outre une étape de correction de ladite donnée correspondant à ladite pluralité de blocs de donnée accédés en réponse à ladite étape de vérification selon ledit au moins un bloc de donnée de redondance correspondant à ladite donnée à lire.

Le procédé selon l'invention permet ainsi de recouvrer des données stockées dans un disque dur même si une surface de ce dernier, sur laquelle sont stockées des données, est hors d'usage.

Selon l'invention, le procédé comprend en outre une étape de mémorisation d'une erreur de lecture d'une donnée dans le disque dur et une étape d'estimation d'un état de fiabilité dudit disque dur, en particulier d'une surface donnée d'un plateau dudit disque dur pour laquelle le plus d'erreurs ont été détectées durant une période de temps donnée.

Le procédé selon l'invention permet ainsi de prévenir un utilisateur d'un risque de panne pouvant conduire à la perte complète de données stockées dans le disque dur.

Toujours selon un mode de réalisation particulier, ledit calcul d'au moins un bloc de donnée de redondance en fonction de chaque bloc de ladite pluralité de blocs de donnée obtenus est basé sur un calcul de parité ou un code correcteur d'erreurs.

L'invention a également pour objet un programme d'ordinateur comprenant des instructions adaptées à la mise en œuvre de chacune des étapes du procédé décrit précédemment lorsque ledit programme est exécuté sur un microcontrôleur ainsi qu'un contrôleur de disque dur comprenant des moyens adaptés à la mise en œuvre de chacune des étapes du procédé décrit précédemment. Les avantages procurés par ce programme d'ordinateur et ce contrôleur de disque dur sont similaires à ceux évoqués précédemment.

L'invention a aussi pour objet un disque dur comprenant une pluralité de plateaux et un contrôleur de disque, le contrôleur de disque étant configuré pour

- obtenir une pluralité de blocs de donnée, chaque bloc de ladite pluralité de blocs de donnée devant être ou étant mémorisé dans le disque dur, le nombre de blocs de ladite pluralité de blocs de donnée étant inférieur au nombre de surfaces de plateaux du disque dur pouvant stocker des données ;
- calculer au moins un bloc de donnée de redondance en fonction de chaque bloc de ladite pluralité de blocs de donnée, le nombre de bloc de donnée de redondance ajouté au nombre de blocs de ladite pluralité de blocs de donnée étant inférieur ou égal au nombre de surfaces de plateaux du disque dur pouvant stocker des donnée ; et
- écrire ledit au moins un bloc de donnée de redondance sur une surface de plateau du disque dur distincte des surfaces utilisées pour mémoriser chaque bloc de ladite pluralité de blocs de donnée.

Le disque dur selon l'invention permet ainsi d'améliorer la fiabilité de stockage de données dans le disque dur en mémorisant les données et des données redondantes sur des plateaux distincts de telle sorte que si un plateau connaît des problèmes de lecture, les données puissent néanmoins être recouvrées.

Selon l'invention, le contrôleur de disque est en outre configuré pour,

- accéder à une pluralité de blocs de donnée correspondant à une donnée à lire dans le disque dur et accéder à au moins un bloc de donnée de redondance correspondant à ladite donnée à lire, chaque bloc de ladite pluralité de blocs de donnée et chaque bloc dudit au moins un bloc de donnée de redondance associé à ladite donnée à lire étant accédé sur une surface distincte de plateau du disque dur ; et
- vérifier l'intégrité de la donnée correspondant à ladite pluralité de blocs de donnée accédés selon ledit au moins un bloc de donnée de redondance correspondant à ladite donnée à lire pour détecter une éventuelle erreur de lecture.

Il est ainsi possible de vérifier que des données accédées dans le disque dur sont valides.

Selon l'invention, le contrôleur de disque est en outre configuré pour :

- mémoriser une erreur de lecture d'une donnée dans le disque dur ; et
- estimer un état de fiabilité dudit disque dur, en particulier d'une surface donnée d'un plateau dudit disque dur pour laquelle le plus d'erreurs ont été détectées durant une période de temps donnée.

D'autres avantages, buts et caractéristiques de la présente invention ressortent de la description détaillée qui suit, faite à titre d'exemple non limitatif, au regard des dessins annexés dans lesquels :

- la figure 1 illustre schématiquement la structure d'un disque dur ;
- la figure 2 représente schématiquement la façon dont sont stockées des données sur une surface d'un plateau ;
- la figure 3 illustre un exemple d'algorithme pouvant être utilisé pour écrire des données dans un disque dur conformément à un premier mode de réalisation de l'invention ;
- la figure 4 illustre un exemple d'algorithme pouvant être utilisé pour lire des données dans un disque dur, ces données ayant été préalablement mémorisées sur le disque dur conformément à un mode de réalisation de l'invention, par exemple le mode de réalisation décrit en référence à la figure 3 ;
- la figure 5 illustre un exemple d'algorithme pouvant être utilisé pour écrire des données dans un disque dur conformément à d'autres modes de réalisation ; et
- la figure 6 illustre schématiquement un exemple d'architecture d'un contrôleur de disque d'un disque dur adapté à mettre en œuvre un mode de réalisation de l'invention, notamment les algorithmes décrits en référence aux figures 3, 4 et 5.

Conformément à un mode de réalisation de l'invention, chaque donnée d'un ensemble de données à mémoriser dans un disque dur est décomposée pour être mémorisée, avec des données de redondance, dans des plateaux distincts afin de permettre la reconstruction de la donnée si un plateau devenait défaillant. La lecture et/ou l'écriture de données sur des plateaux distincts peut être effectuées de façon parallèle ou séquentielle.

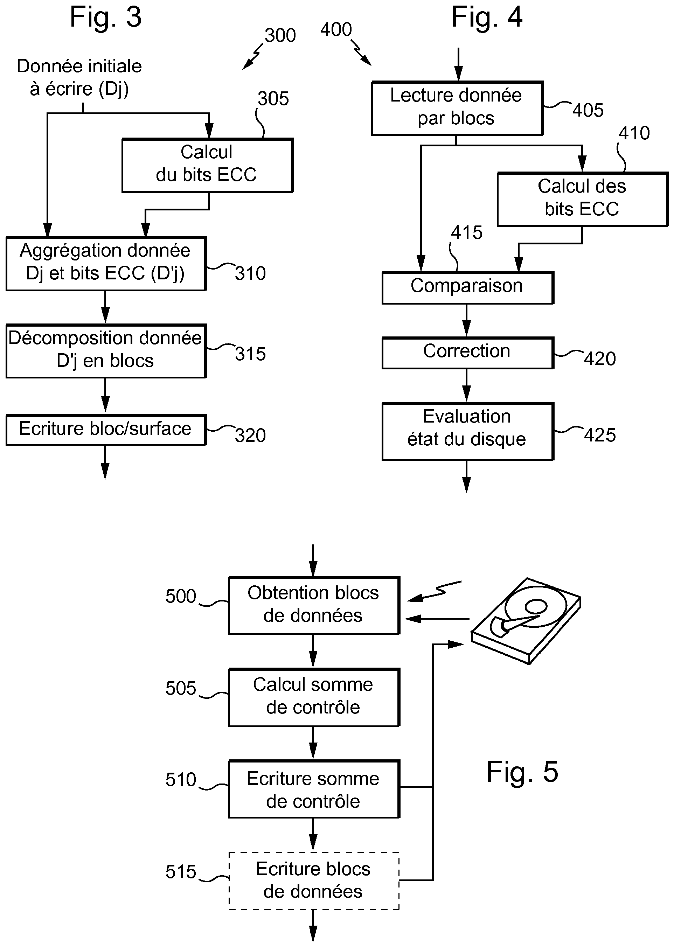

La figure 3 illustre un exemple d'algorithme (300) pouvant être utilisé pour écrire des données dans un disque dur conformément à un premier mode de réalisation de l'invention.

Après avoir reçu une donnée initiale à mémoriser dans le disque dur (donnée « utile »), notée $D_j$, un algorithme de calcul de données de redondance, par exemple un algorithme de calcul d'un code correcteur d'erreurs de type BEC, est appliqué à cette donnée initiale (étape 305) pour produire une donnée de redondance, typiquement des bits ECC (sigle *d'Error Correcting Code* en terminologie anglo-saxonne), par exemple sous la forme d'un ou plusieurs blocs de donnée appelée blocs de donnée de redondance. De tels blocs sont typiquement des octets.

La donnée de redondance calculée est alors agrégée à la donnée initiale $D_j$ pour former une donnée finale $D'_j$ (étape 310) à écrire qui est décomposée en une pluralité de blocs de donnée de taille fixe ou variable (étape 315), notés $B_{i,j}$, où $i$ varie de 1 à $n$. En d'autres termes, la donnée à écrire $D'_j$ est décomposée en n blocs de donnée $B_{i,j}$.

Il est observé ici qu'une donnée de redondance étant généralement obtenue sous forme de blocs, l'étape d'agrégation d'une donnée initiale $D_j$ avec la donnée de redondance correspondante n'est pas toujours nécessaire. Dans ce cas, seule la donnée initiale $D_j$ est décomposée en $m$ blocs $B_{i,j}$ au cours de l'étape 315, $i$ variant de 1 à $m$ (avec $m < n$, les blocs $B_{i,j}$, $j$ variant de $m+1$ à $n$, représentant les blocs de donnée de redondance et correspondant aux blocs de donnée de redondance calculés à l'étape 305).

En outre, il est également noté ici que toutes les données (ou une partie substantielle des données) sont avantageusement écrites sur un disque dur selon un même schéma, les données finales à écrire (c'est-à-dire l'agrégation des données initiales à écrire et des données de redondance) étant scindées en blocs selon un même algorithme puis écrites de façon ordonnées sur des surfaces de plateaux du disque dur.

Par ailleurs, pour faciliter la gestion des adresses et des têtes d'écriture et optimiser les déplacements des bras les supportant, chaque bloc d'une même donnée finale à écrire sur une surface distincte est, de préférence, écrit à la même adresse, c'est-à-dire au même endroit du même secteur de la même piste. Ainsi, chacun de ces blocs peut être écrit de façon parallèle.

La donnée finale est ensuite écrite sous forme de blocs sur plusieurs plateaux du disque dur. A ces fins, les blocs de donnée initiale ainsi que le ou les blocs de donnée de redondance correspondants, c'est-à-dire l'ensemble des blocs $B_{i,j}$, sont écrits sur des surfaces distinctes des plateaux du disque dur (étape 320). En d'autres termes, chaque bloc $B_{i,j}$ est ici écrit, de façon continue ou non, sur une surface distincte $S_i$, $i$ variant de 1 à $n$.

A titre d'illustration, il est considéré ici que la donnée initiale à écrire est codée sur 64 bits et que le code correcteur d'erreurs est codé sur 2 octets. Pour être mémorisée, la donnée initiale est scindée en 8 blocs d'un octet. Chacun des 10 octets de la donnée finale à écrire (8 octets de donnée initiale et 2 octets de code correcteur d'erreurs) est alors écrit sur une surface distincte du disque dur qui requiert ainsi au moins cinq plateaux si des données peuvent être mémorisées sur chacune des deux surfaces de chaque plateau.

Selon cet exemple et un mode de réalisation particulier, le premier octet de chaque donnée stockée sur le disque dur est écrit sur une première surface d'un premier plateau, le second octet de chaque donnée stockée sur le disque dur est écrit sur une seconde surface du premier plateau, le troisième octet de chaque donnée stockée sur le disque dur est écrit sur une première surface d'un second plateau et ainsi de suite jusqu'au huitième octet qui est écrit sur une seconde surface d'un quatrième plateau. De façon similaire, le premier octet de chaque code correcteur d'erreurs de chaque donnée stockée sur le disque dur est écrit sur une première surface d'un cinquième plateau et le second octet de chaque code correcteur d'erreurs de chaque donnée stockée sur le disque dur est écrit sur une seconde surface du cinquième plateau.

Ainsi, si une surface d'un plateau devient illisible pour une raison particulière, par exemple suite à une rayure provoquée par un frottement d'une tête de lecture ou d'écriture sur la surface, il est possible de recouvrer la donnée à l'aide des données redondantes, du fait de la structure de codage par surface.

La figure 4 illustre un exemple d'algorithme (400) pouvant être utilisé pour lire des données dans un disque dur, ces données ayant été préalablement mémorisées sur le disque dur conformément à un mode de réalisation de l'invention, par exemple le mode de réalisation décrit en référence à la figure 3.

La lecture d'une donnée (étape 405) est ici effectuée par blocs, chaque bloc étant lu sur une surface distincte des plateaux du disque dur, conformément à un schéma d'écriture prédéterminé de la donnée.

A nouveau, pour faciliter la gestion des adresses et des têtes de lecture et optimiser les déplacements des bras les supportant, chaque bloc d'une même donnée finale écrit sur une surface distincte est écrit à la même adresse, c'est-à-dire au même endroit du même secteur de la même piste. Ainsi, chacun de ces blocs peut être lu de façon parallèle.

Un algorithme de calcul de données de redondance, par exemple un algorithme de calcul d'un code correcteur d'erreur de type BEC, est alors appliqué aux blocs lus et correspondant à la donnée initiale (étape 410) pour produire une donnée de redondance, typiquement des bits ECC (sigle *d'Error Correcting Code* en terminologie anglo-saxonne), par exemple sous la forme d'un ou plusieurs blocs de donnée de redondance. L'algorithme de calcul de données de redondance utilisé ici est le même que celui ayant servi à calculer les blocs de donnée de redondance lus.

Les blocs de donnée de redondance lus sont ensuite comparés aux blocs de donnée de redondance calculés (étape 415) pour détecter une éventuelle erreur de lecture. Une telle comparaison est par exemple effectuée dans un module appelé *syndrome generatoren* terminologie anglo-saxonne.

Si une erreur de lecture est détectée et s'il est possible de la corriger à l'aide des données de redondance et du résultat de la comparaison, la donnée lue est corrigée (étape 420).

En outre, si une erreur de lecture est détectée, une trace de celle-ci est mémorisée dans le disque dur et une estimation de l'état de fiabilité de ce dernier est effectuée (étape 425). Une telle étape a ici pour objet de prévenir un utilisateur du disque dur d'un état dégradé de ce dernier afin de lui conseiller de faire une copie de son contenu tant que les données (ou une partie de celles-ci) peuvent être récupérées.

L'état du disque dur peut être estimé, par exemple, en comparant le nombre d'erreurs détectées durant une période de temps donnée avec un seuil prédéterminé ou en comparant l'étalage, dans le temps, d'erreurs détectées avec un seuil prédéterminé. Une telle estimation peut être effectuée pour l'ensemble du disque dur ou, de préférence, pour une surface donnée d'un plateau du disque dur, par exemple la surface pour laquelle le plus d'erreurs ont été détectées durant une période de temps donnée.

Lorsque l'état du disque dur atteint un seuil critique, un message d'alarme est, de préférence, transmis à l'utilisateur pour lui permettre d'effectuer une sauvegarde du contenu du disque dur.

La sauvegarde du contenu du disque dur consiste alors, typiquement, à lire toutes les données du disque dur selon un algorithme tel que celui décrit en référence à la figure 4 et à les écrire dans un autre disque dur en utilisant, par exemple, un algorithme tel que celui décrit en référence à la figure 3.

Selon un mode de réalisation particulier, les algorithmes décrits en référence aux figures 3 et/ou 4 sont mis en œuvre sous forme de programmes d'ordinateur, notamment sous forme de *firmware.*

Selon un autre mode de réalisation, une surface d'un plateau est utilisée pour stocker des résultats de calculs de parité, c'est-à-dire des sommes de contrôle, de données initiales (données « utiles ») stockées sur au moins deux autres surfaces de plateaux.

Le calcul de parité peut être effectué sur plusieurs éléments d'une même donnée (par exemple si une donnée est codée sur deux octets et que chacun de ces deux octets est stocké sur une surface distincte de plateau) ou sur plusieurs éléments n'ayant pas de lien entre eux (par exemple si un premier ensemble de données est stocké sur une première surface de plateau et si un second ensemble de données est stocké sur une seconde surface de plateau, distincte de la première).

Selon un mode de réalisation particulier, une donnée initiale à écrire dans le disque dur est décomposée en plusieurs éléments, de préférence de même longueur, chaque élément devant être stocké sur une surface distincte d'un plateau. Une somme de contrôle est calculée pour l'ensemble de ces éléments. Elle est, de préférence, obtenue par l'application de la fonction logique XOR à l'ensemble des éléments de la donnée initiale. Ces éléments de la donnée initiale et la somme de contrôle (c'est-à-dire le résultat du calcul de parité) sont chacun stockés sur une surface distincte de plateau.

Ainsi, à titre d'illustration, lorsqu'une donnée initiale est décomposée en $n$ éléments $E_i$ ($i$ variant de 1 à $n$), par exemple $n$ octets, la somme de contrôle Sc peut être obtenue par application de la fonction XOR (notée $\oplus$) à chaque élément $E_i$ de la façon suivante :

$$Sc = E_1 \oplus E_2 \oplus \ldots \oplus E_n$$

Lorsqu'un élément comprend plusieurs éléments unitaires (par exemple plusieurs bits), le calcul de parité peut être effectué élément unitaire par élément unitaire (par exemple bit à bit).

Selon un autre mode de réalisation particulier, des données initiales, liées ou non entre elles, sont mémorisées par paquets dans le disque dur. Chaque paquet comprend ici un nombre de données initiales prédéterminé et chaque donnée initiale d'un paquet est ici stockée sur une surface distincte d'un plateau. Une somme de contrôle est alors calculée pour l'ensemble des données initiales de chaque paquet. A nouveau, cette somme de contrôle peut être obtenue par l'application de la fonction logique XOR.

A titre d'illustration, lorsqu'un ensemble de *n* données initiales $D_i$ (*i* variant de 1 à *n*) doit être mémorisé dans le disque dur, la somme de contrôle Sc peut être obtenue par application de la fonction XOR à chaque donnée initiale $D_i$ de la façon suivante, élément unitaire par élément unitaire (par exemple bit à bit) :

$$Sc = D_1 \oplus D_2 \oplus \ldots \oplus D_n$$

Les données initiales et la somme de contrôle sont alors chacun stockés sur une surface distincte de plateau.

Toujours selon un autre mode de réalisation particulier, une donnée initiale est mémorisée sur une surface de plateau d'un disque dur. Avant ou après que la donnée initiale ne soit mémorisée, des données mémorisées sur d'autres surfaces de plateau du disque dur, par exemple sur chaque autre surface de plateau du disque dur, à l'exception de la surface de plateau utilisée pour mémoriser des sommes de contrôle, est obtenue (typiquement lue) pour permettre le calcul d'une somme de contrôle correspondante. A titre d'illustration, ces données peuvent être déterminées selon l'adresse physique (typiquement définie par un cylindre, une tête et un secteur), pour chaque surface de plateau du disque, à l'exception de celles utilisées pour stocker la donnée initiale à mémoriser et des sommes de contrôle, à laquelle est ou doit être stockée la donnée initiale à mémoriser. Une somme de contrôle de la donnée initiale à mémoriser et des données obtenues est alors calculée. A nouveau, cette somme de contrôle peut être obtenue par l'application de la fonction logique XOR.

A titre d'illustration, lorsqu'une données initiale *D* doit être mémorisée à une adresse particulière d'une surface de plateau, les données mémorisées à la même adresse sur les autres surfaces de plateau, à l'exception de la surface de plateau utilisée pour mémoriser les sommes de contrôle, appelées $D'_i$, (*i* variant de 2 à *n*) sont obtenues et la somme de contrôle *Sc* est calculée, par exemple par application de la fonction XOR de la façon suivante :

$$Sc = D_1 \oplus D'_2 \oplus \ldots \oplus D'_n$$

De façon similaire, il est possible de calculer une somme de contrôle visant plusieurs données initiales à stocker et plusieurs données lues, ces données étant stockées ou lues sur des surfaces distinctes de plateau.

Toujours selon un autre mode de réalisation particulière, les données à partir desquelles des sommes de contrôle doivent être calculées et mémorisées sont déjà mémorisées dans le disque dur. Ces données mémorisées sont ainsi lues pour permettre le calcul de sommes de contrôle qui sont alors mémorisées sur une surface de plateau distincte.

Un exemple d'étapes de ces modes de réalisation est illustré sur la figure 5.

Une première étape (étape 500) vise à obtenir les blocs de donnée devant être utilisés pour calculer une somme de contrôle. Comme illustré de façon schématique, ces blocs peuvent provenir d'une interface de communication ou du disque dur. Ainsi, selon le mode de réalisation mis en œuvre, tous les blocs de donnée viennent de l'interface de communication (typiquement lorsque ces blocs de donnée doivent être mémorisés dans le disque dur), tous les blocs viennent du disque dur (lorsque les blocs ont déjà été mémorisés et qu'une fonction de sécurisation des données est appelée) ou un ou plusieurs blocs de donnée viennent de l'interface de communication et un ou plusieurs blocs de donnée viennent du disque dur (typiquement lorsqu'une donnée à mémorisée est stockée sur une seule surface de plateau).

Une somme de contrôle est calculée dans une étape suivante (étape 505) à partir des blocs de donnée préalablement obtenus. Comme décrit précédemment, la somme de contrôle peut notamment être calculée à l'aide de la fonction logique XOR, par exemple en appliquant cette fonction à chaque bit de tous les blocs.

Si chaque bloc de donnée comprend *m* bits notés $B_{i,j}$ où *i* représente un index de block de donnée et *j* représente un index sur les bits au sein du bloc de donnée $B_i$, si la somme de contrôle est calculée sur *n* blocs de donnée, le bit *j* de la somme de contrôle *Sc* peut s'exprimer de la façon suivante :

$$Sc_j = B_{1,j} \oplus B_{2,j} \oplus \ldots \oplus B_{n,j}$$

La somme de contrôle obtenue est ensuite mémorisée dans le disque dur, sur une surface de plateau prédéterminée (étape 510).

Les blocs de donnée à partir desquels a été obtenue la somme de contrôle et qui proviennent de l'interface de communication sont ensuite, le cas échéant, de préférence, mémorisés dans le disque dur (étape 515). Chaque bloc est stocké sur une surface distincte de plateau, différente des surfaces de plateau d'où proviennent, le cas échéant, les blocs de donnée utilisés pour calculer la somme de contrôle.

Selon un autre mode de réalisation encore, plusieurs surfaces de plateau sont utilisées pour stocker des données de redondance. Ainsi, en utilisant *n* surfaces de plateau pour mémoriser des données de redondances, obtenues à partir de mécanismes distincts, il est possible de recouvrer des données lorsque les données mémorisées sur plusieurs surfaces de plateau sont illisibles : jusqu'à *n* surfaces peuvent typiquement présenter des problèmes de lecture.

Un tel mode de réalisation met en œuvre un principe similaire à celui utilisé dans les systèmes connus sous le nom de RAID-6.

Ainsi, par exemple, l'invention peut être mise en œuvre dans un disque dur comprenant quatre surfaces de plateau pour stocker des données initiales (données « utiles ») et deux surfaces de plateau pour stocker des données de redondance (disque 4 + 2) ou dans un disque dur comprenant huit surfaces de plateau pour stocker des données initiales et deux surfaces de plateau pour stocker des données de redondance (disque 8 + 2). De tels disques durs permettent de mettre en œuvre un mécanisme de quorum permettant de détecter et corriger des erreurs.

A nouveau, pour ces différents modes de réalisation, si une erreur de lecture est détectée, une trace de celle-ci est mémorisée dans le disque dur et une estimation de l'état de fiabilité de ce dernier est effectuée afin de prévenir un utilisateur du disque dur d'un état dégradé de ce dernier et lui conseiller de faire une copie de son contenu tant que les données (ou une partie de celles-ci) peuvent être récupérées.

L'état du disque dur peut notamment être estimé en comparant le nombre d'erreurs détectés durant une période de temps donnée avec un seuil prédéterminé ou en comparant l'étalage, dans le temps, d'erreurs détectées avec un seuil prédéterminé. Une telle estimation peut être effectuée pour l'ensemble du disque dur ou, de préférence, pour une surface donnée d'un plateau du disque dur, par exemple la surface pour laquelle le plus d'erreurs ont été détectées durant une période de temps donnée.

Lorsque l'état du disque dur atteint un seuil critique, un message d'alarme est, de préférence, transmis à l'utilisateur pour lui permettre d'effectuer une sauvegarde du contenu du disque dur.

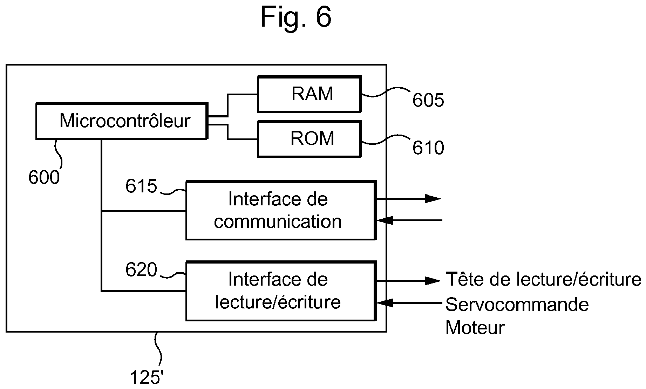

La figure 6 illustre schématiquement un exemple d'architecture d'un contrôleur de disque d'un disque dur adapté à mettre en œuvre un mode de réalisation de l'invention, notamment les algorithmes décrits en référence aux figures 3, 4 et 5.

Comme illustré, le contrôleur de disque 125' comprend ici un microcontrôleur 600 (ou CPU, sigle de *Central Processing Unit* en terminologie anglo-saxonne). Celui-ci est ici relié à

- une première mémoire 605, par exemple une mémoire de type RAM (acronyme de *Random Access Memory* en terminologie anglo-saxonne), comportant des registres adaptés à enregistrer des variables et paramètres créés et modifiés au cours de l'exécution de programmes, en particulier des données à écrire dans le disque dur ou des données lues dans le disque dur ;

- une seconde mémoire 610, par exemple une mémoire de type EEPROM (acronyme d'*Electrically-Erasable Programmable Read Only Memory* en terminologie anglo-saxonne), adaptée par exemple à stocker des programmes mettant en œuvre les algorithmes décrits en référence aux figures 3, 4 et 5 ainsi que des données relatives à des erreurs de lecture ;
- une interface de communication 615 ; et
- une interface de lecture/écriture 620.

L'interface de communication 615 est typiquement reliée à un ordinateur, par exemple via un bus SCSI. L'interface de lecture/écriture 620 est reliée au moteur entraînant les plateaux, au servocommande des bras comprenant les têtes de lecture et d'écriture ainsi qu'à ces dernières.

Le microcontrôleur 600 commande et dirige l'exécution des instructions ou portions de code logiciel du ou des programmes.

Naturellement, pour satisfaire des besoins spécifiques, une personne compétente dans le domaine de l'invention pourra appliquer des modifications dans la description précédente. La présente invention ne se limite pas aux formes de réalisation décrites, d'autres variantes et combinaisons de caractéristiques sont possibles.

La présente invention a été décrite et illustrée dans la présente description détaillée en référence aux figures jointes. Toutefois, la présente invention ne se limite pas aux formes de réalisation présentées. D'autres variantes et modes de réalisation peuvent être déduits et mis en œuvre par la personne compétente dans le domaine de l'invention à la lecture de la présente description et des figures annexées.

Dans les revendications, le terme « comporter » n'exclut pas d'autres éléments ou d'autres étapes. L'article indéfini « un » n'exclut pas le pluriel. Un seul processeur ou plusieurs autres unités peuvent être utilisées pour mettre en œuvre l'invention. Les différentes caractéristiques présentées et/ou revendiquées peuvent être avantageusement combinées. Leur présence dans la description ou dans des revendications dépendantes différentes n'exclut pas, en effet, la possibilité de les combiner. Les signes de référence ne sauraient être compris comme limitant la portée de l'invention.

**Revendications**

1. Procédé pour contrôleur de disque dur comprenant une pluralité de plateaux, pour améliorer la fiabilité du disque dur, chaque plateau comprenant au moins une surface de stockage de données, le procédé comprenant les étapes suivantes :

- obtention (500) d'une pluralité de blocs de donnée, chaque bloc de ladite pluralité de blocs de donnée devant être ou étant mémorisé dans le disque dur, le nombre de blocs de ladite pluralité de blocs de donnée étant inférieur au nombre de surfaces de plateaux du disque dur pouvant stocker des données ;
- calcul (305, 505) d'au moins un bloc de donnée de redondance en fonction de chaque bloc de ladite pluralité de blocs de donnée, le nombre de bloc de donnée de redondance ajouté au nombre de blocs de ladite pluralité de blocs de donnée étant inférieur ou égal au nombre de surfaces de plateaux du disque dur pouvant stocker des données ;
- écriture (320, 510) dudit au moins un bloc de donnée de redondance sur une surface de plateau du disque dur, distincte des surfaces utilisées pour mémoriser chaque bloc de ladite pluralité de blocs de donnée ;
- accès (405) à une pluralité de blocs de donnée correspondant à une donnée à lire dans le disque dur et accès à au moins un bloc de donnée de redondance correspondant à ladite donnée à lire, chaque bloc de ladite pluralité de blocs de donnée accédés et chaque bloc dudit au moins un bloc de donnée de redondance associé à ladite donnée à lire étant accédé sur une surface distincte de plateau du disque dur ; le procédé étant **caractérisé en ce qu'**il comprend en outre les étapes suivantes :

> - vérification (415) de l'intégrité de la donnée correspondant à ladite pluralité de blocs de donnée accédés selon ledit au moins un bloc de donnée de redondance correspondant à ladite donnée à lire pour détecter une éventuelle erreur de lecture ;
> - mémorisation d'une erreur de lecture d'une donnée dans le disque dur ; et
> - estimation (425) d'un état de fiabilité d'une surface donnée d'un plateau dudit disque dur pour laquelle le plus d'erreurs ont été détectées durant une période de temps donnée.

**2.** Procédé selon la revendication 1 selon lequel ladite étape d'obtention d'une pluralité de blocs de donnée comprend une étape de lecture, sur une surface de plateau du disque dur, d'au moins un bloc de ladite pluralité de blocs de donnée.

**3.** Procédé selon la revendication 1 selon lequel au moins un bloc de ladite pluralité de blocs de donnée est obtenu via une interface de communication.

**4.** Procédé selon la revendication 1 ou la revendication 3, comprenant en outre une étape de décomposition (315) d'une donnée reçue à mémoriser dans le disque dur en ladite pluralité de blocs de donnée.

**5.** Procédé selon la revendication 3 ou la revendication 4 comprenant en outre une étape d'écriture d'au moins un bloc de ladite pluralité de blocs de donnée sur une surface de plateau du disque dur.

**6.** Procédé selon l'une quelconque des revendications 1 à 5 selon lequel ladite étape de vérification comprend une étape de calcul d'au moins un bloc de donnée de redondance.

**7.** Procédé selon l'une quelconque des revendications 1 à 6 comprenant en outre une étape de correction (420) de ladite donnée correspondant à ladite pluralité de blocs de donnée accédés en réponse à la dite étape de vérification selon ledit au moins un bloc de donnée de redondance correspondant à ladite donnée à lire.

**8.** Procédé selon l'une quelconque des revendications 1 à 7 comprenant en outre une étape d'écriture, à la même adresse, de chaque bloc d'une même donnée finale à écrire sur une surface distincte.

**9.** Procédé selon l'une quelconque des revendications précédentes selon lequel ledit calcul d'au moins un bloc de donnée de redondance en fonction de chaque bloc de ladite pluralité de blocs de donnée obtenus est basé sur un calcul de parité ou un code correcteur d'erreurs.

**10.** Programme d'ordinateur comprenant des instructions adaptées à la mise en œuvre de chacune des étapes du procédé selon l'une quelconque des revendications 1 à 9 lorsque ledit programme est exécuté sur un microcontrôleur.

**11.** Contrôleur de disque dur comprenant des moyens adaptés à la mise en œuvre de chacune des étapes du procédé selon l'une quelconque des revendications 1 à 9.

**12.** Disque dur comprenant une pluralité de plateaux et un contrôleur de disque dur selon la revendication 11

**Patentansprüche**

**1.** Verfahren für Harddiskcontroller, umfassend eine Vielzahl von Platten zur Verbesserung der Zuverlässigkeit der Harddisk, wobei jede Platte mindestens eine Datenspeicheroberfläche umfasst, wobei das Verfahren die folgenden Schritte umfasst:

> - Erhalten (500) einer Vielzahl von Datenblöcken, wobei jeder Block von der Vielzahl von Datenblöcken auf der Harddisk gespeichert werden muss oder ist, wobei die Anzahl von Blöcken von der Vielzahl von Datenblöcken kleiner als die Anzahl von Plattenoberflächen der Harddisk ist, die Daten speichern können;

- Berechnen (305, 505) mindestens eines Redundanzdatenblocks in Abhängigkeit von jedem Block von der Vielzahl von Datenblöcken, wobei die der Anzahl von Blöcken von der Vielzahl von Datenblöcken hinzugefügte Anzahl von Redundanzdatenblöcken kleiner oder gleich der Anzahl von Plattenoberflächen der Harddisk ist, die Daten speichern können;

- Schreiben (320, 510) des mindestens einen Redundanzdatenblocks auf eine Plattenoberfläche der Harddisk, die sich von den Oberflächen unterscheidet, die zum Speichern jedes Blocks von der Vielzahl von Datenblöcken verwendet wird;

- Zugriff (405) auf eine Vielzahl von Datenblöcken, die einem auf der Harddisk zu lesenden Datenelement entsprechen, und Zugriff auf mindestens einen Redundanzdatenblock, der dem zu lesenden Datenelement entspricht, wobei der Zugriff auf jeden Block von der Vielzahl von Datenblöcken, auf die der Zugriff erfolgt, und auf jeden Redundanzdatenblock, der dem zu lesenden Datenelement zugeordnet ist, auf einer unterschiedlichen Plattenoberfläche der Harddisk erfolgt; wobei das Verfahren **dadurch gekennzeichnet ist, dass** es auch die folgenden Schritte umfasst:

    - Überprüfen (415) der Integrität des Datenelements, das der Vielzahl von Datenblöcken entspricht, auf die gemäß dem mindestens einen Redundanzdatenblock, der dem zu lesenden Datenelement entspricht, der Zugriff erfolgte, um einen potenziellen Lesefehler zu ermitteln;
    - Speichern eines Lesefehlers eines Datenelements auf der Harddisk; und
    - Schätzen (425) eines Zuverlässigkeitszustands einer gegebenen Plattenoberfläche der Harddisk, für welche die meisten Fehler innerhalb einer gegebenen Zeitdauer ermittelt wurden.

2. Verfahren nach Anspruch 1, wobei der Schritt des Erhaltens einer Vielzahl von Datenblöcken einen Leseschritt auf einer Plattenoberfläche der Harddisk von mindestens einem Block von der Vielzahl von Datenblöcken umfasst.

3. Verfahren nach Anspruch 1, wobei mindestens ein Block von der Vielzahl von Datenblöcken über eine Kommunikationsschnittstelle erhalten wird.

4. Verfahren nach Anspruch 1 oder Anspruch 3, umfassend ferner einen Schritt des Aufteilens (315) eines zum Speichern auf der Harddisk erhaltenen Datenelements in die Vielzahl von Datenblöcken.

5. Verfahren nach Anspruch 3 oder Anspruch 4, umfassend ferner einen Schritt des Schreibens von mindestens einem Block von der Vielzahl von Datenblöcken auf einer Plattenoberfläche der Harddisk.

6. Verfahren nach einem der Ansprüche 1 bis 5, wobei der Schritt des Überprüfens einen Schritt des Berechnens von mindestens einem Redundanzdatenblock umfasst.

7. Verfahren nach einem der Ansprüche 1 bis 6, umfassend ferner einen Schritt des Korrigierens (420) des Datenelements, das der Vielzahl von Datenblöcken entspricht, auf die als Antwort auf den Schritt des Überprüfens gemäß den mindestens einen Redundanzdatenblock, der dem zu lesenden Datenelements entspricht, der Zugriff erfolgte.

8. Verfahren nach einem der Ansprüche 1 bis 7, umfassend ferner einen Schritt des Schreibens, an derselben Adresse, jedes zum Schreiben auf einer unterschiedlichen Oberfläche Blocks eines selben endgültigen Datenelements.

9. Verfahren nach einem der vorangehenden Ansprüche, wobei die Berechnung von mindestens einem Redundanzdatenblock in Abhängigkeit von jedem Block von der Vielzahl erhaltener Datenblöcke auf einer Paritätsberechnung oder einem Fehlerkorrekturcode basiert.

10. Rechnerprogramm, umfassend Befehle, die für die Durchführung von jedem der Schritte des Verfahrens nach einem der Ansprüche 1 bis 9 geeignet sind, wenn das Programm auf einem Mikrocontroller ausgeführt wird.

11. Harddiskcontroller, umfassend Mittel, die zur Durchführung von jedem der Schritte des Verfahrens nach einem der Ansprüche 1 bis 9 geeignet sind.

12. Harddisk, umfassend eine Vielzahl von Platten und einen Harddiskcontroller nach Anspruch 11.

**Claims**

1. A method for a hard disk controller comprising a plurality of platters, for improving the reliability of the hard disk, each platter comprising at least one data storage surface, the method comprising the following steps of:

- obtaining (500) a plurality of data blocks, each block of said plurality of data blocks having to be or being stored in the hard disk, the number of blocks of said plurality of data blocks being lower than the number of platter surfaces of the hard disk which can store data;

- calculating (305, 505) at least one redundancy data block as a function of each block of said plurality of data blocks, the number of redundancy data block added to the number of blocks of said plurality of data blocks being lower than or equal to the number of platter surfaces of the hard disk which can store data;

- writing (320, 510) said at least one redundancy data block on a platter surface of the hard disk, distinct from the surfaces used to store each block of said plurality of data blocks;

- accessing (405) a plurality of data blocks corresponding to a piece of data to be read in the hard disk and accessing at least one redundancy data block corresponding to said piece of data to be read, each block of said plurality of data blocks accessed and each redundancy data block associated with said piece of data to be read being accessed on a distinct platter surface of the hard disk; the method being **characterised in that** it furthermore comprises the following steps of:

- checking (415) the integrity of the piece of data corresponding to said plurality of data blocks accessed according to said at least one redundancy data block corresponding to said piece of data to be read to detect a potential reading error;

- storing a reading error of a piece of data in the hard disk; and

- estimating (425) a reliability state of a given platter surface of said hard disk for which most errors were detected during a given time period.

2. The method according to claim 1, wherein said step of obtaining a plurality of data blocks comprises a step of reading, on a platter surface of the hard disk, at least one block of said plurality of data blocks.

3. The method according to claim 1, wherein at least one block of said plurality of data blocks is obtained via a communication interface.

4. The method according to claim 1 or claim 3, further comprising a step of splitting (315) a received piece of data to be stored in the hard disk into said plurality of data blocks.

5. The method according to claim 3 or claim 4, further comprising a step of writing at least one block of said plurality of data blocks on a platter surface of the hard disk.

6. The method according to any of claims 1 to 5, wherein said checking step comprises a step of calculating at least one redundancy data block.

7. The method according to any of claims 1 to 6, further comprising a step of correcting (420) said piece of data corresponding to said plurality of accessed data blocks in response to said checking step according to said at least one redundancy data block corresponding to said piece of data to be read.

8. The method according to any of claims 1 to 7, further comprising a step of writing, to the same address, each block of a same final piece of data to be written on a distinct surface.

9. The method according to any of the preceding claims, wherein said calculating at least one redundancy data block as a function of each block of said plurality of data blocks obtained is based on a parity calculation or an error correcting code.

10. A computer program comprising instructions adapted to implement each of the steps of the method according to any of claims 1 to 9 when said program is run on a microcontroller.

11. A hard disk controller comprising means adapted to implement each of the steps of the method according to any of claims 1 to 9.

12. A hard disk comprising a plurality of platters and a hard disk controller according to claim 11.

Fig. 1

Fig. 2

# Fig. 3

300

Donnée initiale
à écrire (Dj)

Calcul
du bits ECC — 305

Aggrégation donnée
Dj et bits ECC (D'j) — 310

Décomposition donnée
D'j en blocs — 315

Ecriture bloc/surface — 320

# Fig. 4

400

Lecture donnée
par blocs — 405

Calcul des
bits ECC — 410

415

Comparaison

Correction — 420

Evaluation
état du disque — 425

500 — Obtention blocs
de données

505 — Calcul somme
de contrôle

510 — Ecriture somme
de contrôle

515 — Ecriture blocs
de données

# Fig. 5

# Fig. 6

**EP 2 909 725 B1**

## RÉFÉRENCES CITÉES DANS LA DESCRIPTION

**Documents brevets cités dans la description**

- US 20060107131 A